# EUROPEAN PATENT APPLICATION

(11) **EP 4 764 526 A1**
(43) Date of publication of application: **24.06.2026**
(21) Application number: 25745456.1
(22) Date of filing: 15.01.2025
(51) Int. Cl.: G01R 31/367, G01R 31/396, G01R 31/382, G01R 31/392

(54) **BATTERY DIAGNOSTIC APPARATUS AND OPERATION METHOD THEREOF**

(30) Priority: 25.01.2024 KR 20240011496
(71) Applicant: LG Energy Solution, Ltd., Seoul 07335 (KR)
(72) Inventor: BYEON, Min Jeong, Daejeon 34122 (KR); JIN, Hee Jun, Daejeon 34122 (KR); CHOI, Jee Soon, Daejeon 34122 (KR)
(74) Representative: Goddar, Heinz J.
(86) International application number: PCT/KR2025/000863
(87) International publication number: WO 2025/159439

(57) **Abstract**

According to an embodiment disclosed herein, a battery diagnostic device may include an information acquisition unit configured to acquire battery data in a charge/discharge cycle of each of a plurality of battery cells included in a battery pack and a controller configured to calculate predicted data that predicts an abnormality of each of the plurality of battery cells for each charge/discharge cycle of the battery cell based on the battery data, preprocess the predicted data in at least one manner, and derive a diagnosis result for each charge/discharge cycle of each of the plurality of battery cells based on the preprocessed predicted data.

## Description

### CROSS-REFERENCE TO RELATED APPLICATION

The present application claims the benefit of the priority of Korean Patent Application No. 10-2024-0011496, filed on January 25, 2024, which is hereby incorporated by reference in its entirety.

### TECHNICAL FIELD

Embodiments disclosed herein relate to a battery diagnostic device and a method of operating the same.

### BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of having a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

The secondary batteries are in the form of a battery pack (or module) including a plurality of cells, so that their range of applications is expanding to various fields including an electric vehicle, and accordingly, importance of battery pack diagnosis is increasing day by day. In particular, since the battery pack includes numerous battery cells and a secondary battery may be charged and discharged, technology for specify an abnormal cell and a point in time at which an abnormality has occurred is required.

In the case of existing battery diagnosis methods, there is a problem in that it is impossible to specify exactly a point in time (cycle) at which an abnormality has occurred in the battery cell. Accordingly, a cell in which an abnormality has occurred has to be processed as having the abnormality at all points in time (cycles), and thus there is a problem in that an over-detection rate in a diagnosis result of the battery pack increases.

### DISCLOSURE OF THE INVENTION

### TECHNICAL PROBLEM

The embodiments disclosed herein are directed to providing a battery diagnostic device capable of more accurately specifying a point in time at which an abnormality has occurred in a battery cell and a method of operating the same.

The embodiments disclosed herein are also directed to providing a battery diagnostic device capable of identifying an abnormal sign of a battery through diagnosis of a battery in actual operation to prevent accidents such as fire and a method of operating the same.

The technical problems of the embodiments disclosed herein are not limited to those mentioned above, and other objectives not mentioned will be clearly understood by those skilled in the art from the following descriptions.

### TECHNICAL SOLUTION

According to an embodiment disclosed herein, a battery diagnostic device includes an information acquisition unit configured to acquire battery data in a charge/discharge cycle of each of a plurality of battery cells included in a battery pack and a controller configured to calculate predicted data that predicts an abnormality of each of the plurality of battery cells for each charge/discharge cycle of the battery cell based on the battery data, preprocess the predicted data in at least one manner, and derive a diagnosis result for each charge/discharge cycle of each of the plurality of battery cells based on the preprocessed predicted data.

According to the embodiment, the controller may convert the predicted data by assigning a weight determined according to the charge/discharge cycle to the predicted data.

According to the embodiment, the controller may, for each of the plurality of battery cells, express the predicted data as binary data, and convert the predicted data based on the number of charge/discharge cycles in which the predicted data has a first value.

According to the embodiment, the controller may, for each of the plurality of battery cells, convert the predicted data for all charge/discharge cycles into the first value when the number of charge/discharge cycles in which the predicted data has the first value is equal to or greater than a preset ratio and convert the predicted data for all charge/discharge cycles into a median value of the predicted data when the number of charge/discharge cycles in which the predicted data has the first value is less than the preset ratio.

According to the embodiment, the controller may apply an interquartile range (IQR) to the predicted data to remove data outside a preset range.

According to the embodiment, the controller may compare the preprocessed predicted data with a threshold value to derive the diagnosis result.

According to the embodiment, the controller may acquire the predicted data using a pre-trained diagnostic model.

According to an embodiment disclosed herein, a method of diagnosing a battery includes acquiring battery data in a charge/discharge cycle of each of a plurality of battery cells included in a battery pack, calculating predicted data that predicts an abnormality of each of the plurality of battery cells for each charge/discharge cycle of the battery cell based on the battery data, preprocessing the predicted data in at least one manner, and deriving a diagnosis result for each charge/discharge cycle of each of the plurality of battery cells based on the preprocessed predicted data.

According to the embodiment, in the preprocessing of the predicted data in at least one manner, the predicted data may be converted by assigning a weight determined according to the charge/discharge cycle to the predicted data.

According to the embodiment, in the preprocessing of the predicted data in at least one manner, the predicted data may be expressed as binary data, and the predicted data may be converted based on the number of charge/discharge cycles in which the predicted data has a first value.

According to the embodiment, in the preprocessing of the predicted data in at least one manner, the predicted data for all charge/discharge cycles may be converted into the first value when the number of charge/discharge cycles in which the predicted data has the first value is equal to or greater than a preset ratio, and the predicted data for all charge/discharge cycles may be converted into a median value of the predicted data when the number of charge/discharge cycles in which the predicted data has the first value is less than the preset ratio.

According to the embodiment, the preprocessing of the predicted data in at least one manner, an interquartile range (IQR) may be applied to the predicted data to remove data outside a preset range.

### ADVANTAGEOUS EFFECTS

A battery diagnostic device and a method of operating the same according to the embodiments disclosed herein can more accurately specify a point in time at which an abnormality has occurred in a battery cell. Accordingly, an over-detection rate of battery diagnosis results can be reduced.

Besides, various effects may be provided that are directly or indirectly identified through the present disclosure.

### BRIEF DESCRIPTION OF THE DRAWINGS

FIG. 1 is a block diagram showing a configuration of a battery diagnostic device according to an embodiment disclosed herein.
FIGS. 2a and 2b are views showing an example of a result obtained by applying a preprocessing method according to an embodiment disclosed herein.
FIGS. 3a and 3b are views showing an example of a result obtained by applying a preprocessing method according to another embodiment disclosed herein.
FIG. 3c is a diagram showing a process in which a preprocessing method according to another embodiment disclosed herein is applied.
FIGS. 4a and 4b are views showing an example of a result obtained by applying a preprocessing method according to yet another embodiment disclosed herein.
FIG. 5 is a flowchart for describing a method of diagnosing a battery according to an embodiment disclosed herein.
FIG. 6 is a block diagram showing a hardware configuration of a computing system for performing a method of operating a battery diagnostic device according to an embodiment disclosed herein.

### MODE FOR CARRYING OUT THE INVENTION

Hereinafter, various embodiments disclosed in the present invention will be described with reference to the accompanying drawings. However, this is not intended to limit the present invention to the specific embodiments, and it is to be construed to include various modifications, equivalents, and/or alternatives of embodiments of the present invention.

Herein, it is to be understood that a singular form of a noun corresponding to an item may include one or more of the things, unless the relevant context clearly indicates otherwise. As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," or "first" and "second" may be used to simply distinguish a corresponding component from another, and do not limit the components in other aspects (e.g., importance or order). It is to be understood that if an element (e.g., a first element) is referred to, with or without the term "operatively" or "communicatively," as "coupled to," "coupled to," "connected with," or "connected to" another element (e.g., a second element), it means that the element may be coupled to the other element directly (e.g., by wire), wirelessly, or via a third element.

Each of the components described herein (e.g., a module or program) may contain a single entity or a plurality of entities. According to various embodiments, one or more of the components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "unit" may include a unit implemented in hardware, software, or firmware, and may interchangeably be used with other terms, such as "logic," "logic block," "part," or "circuitry." A module may be a single integral component, or a minimum unit or part thereof, adapted to perform one or more functions. For example, according to one embodiment, the module may be implemented in a form of an application-specific integrated circuit (ASIC).

Various embodiments set forth herein may be implemented as software (e.g., a program or an application) including one or more instructions that are stored in a storage medium (e.g., a memory) that is readable by a machine. For example, a processor of the machine may invoke at least one of the one or more instructions stored in the storage medium, and execute it. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

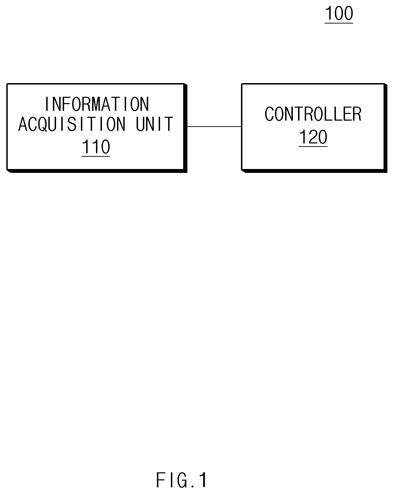

FIG. 1 is a block diagram showing the configuration of a battery diagnostic device according to an embodiment disclosed herein.

Referring to FIG. 1, a battery diagnostic device 100 may include an information acquisition unit 110 and a controller 120.

The battery diagnostic device 100 may diagnose an abnormality of a battery pack including a plurality of battery cells. In particular, the battery diagnostic device 100 may diagnose an abnormality of each battery cell for each charge/discharge cycle. In this way, the battery diagnostic device 100 may specify a point in time at which an abnormality has occurred in the battery cell, and may increase the diagnostic accuracy of the battery pack to reduce an over-detection rate.

The operation of the battery diagnostic device 100 below may be performed by a battery management system (BMS) within a vehicle or a battery BMS provided within the battery pack, and may also be performed in various devices such as a server, a cloud, a charger, or a charger/discharger.

The information acquisition unit 110 may acquire battery data from a charge/discharge cycle of each of a plurality of battery cells included in the battery pack. Here, each charge/discharge cycle may mean a cycle in which charging and discharging of the battery are performed.

The battery data may include data about a voltage of the battery. In addition, the information acquisition unit 110 may also acquire battery-related data such as temperature, the state of health (SOH), and the state of charge (SOC) of each battery cell.

The information acquisition unit 110 may be implemented as a battery management system (BMS), a charger/discharger, or a component related to a battery. In some cases, the information acquisition unit 110 may be implemented as a separate component from the BMS and the charger/discharger (e.g., an external server) to acquire data from the BMS and the charger/discharger.

The controller 120 may calculate predicted data that predicts an abnormality of a battery cell for each charge/discharge cycle of each of the plurality of battery cells based on battery data. The controller 120 may primarily predict an abnormality in each charge/discharge cycle for each battery cell.

According to the embodiment, the controller 120 may calculate the predicted data using a pre-trained diagnostic model. The diagnostic model may be trained to derive a diagnosis result using training data. For example, the diagnostic model may be trained using a supervised learning method that takes training data pairs (battery data - abnormality) as input and predicts the diagnosis results. For another example, the diagnostic model may be trained using an unsupervised learning method that only takes battery data as input and predicts the diagnosis result. In addition, it goes without saying that the diagnostic model may be trained through various learning methods.

The output of the pre-trained diagnostic model may be in the form of binary data indicating whether there is an abnormality or not. For example, the pre-trained diagnostic model may output 1 when the battery cell is predicted to be abnormal and output 0 when the battery cell is predicted to be normal. For another example, the pre-trained diagnostic model may output a probability that a battery cell is abnormal.

The controller 120 may preprocess the predicted data in at least one manner. The controller 120 may further increase diagnostic accuracy by preprocessing the predicted data.

In an embodiment, the controller 120 may preprocess the predicted data by assigning a weight. The controller 120 may convert the predicted data by assigning a weight determined according to the charge/discharge cycle to the predicted data. That is, the controller 120 may preprocess the predicted data by calculating the predicted data and the weight.

The weight may be determined according to the charge/discharge cycle. For example, the controller 120 may assign a weight that increases as the charge/discharge cycle progresses. This is because the battery cell initially has a low rate of abnormality, but the rate of abnormality may increase as the number of charge/discharge cycles increases. For example, when the number of charge/discharge cycles is n (where n is a natural number equal to or greater than 2), the weight assigned in a kth cycle (where k is a natural number less than or equal to n) may be k/n. The weight is only exemplary, and there are no restrictions on a method of assigning the weight.

According to another embodiment, the controller 120 may express the predicted data as binary data.

The controller 120 may express the predicted data as binary data. For example, binary data may mean data having either a first value (e.g., 1) or a second value (e.g., 0). Here, the first value may be a value indicating that the battery cell is abnormal, and the second value may be a value indicating that the battery cell is normal.

The predicted data may be expressed as binary data from the beginning, and in some cases, data expressed as probability values may be converted into binary data. In this case, the predicted data may be converted into binary data by comparing the probability value of the predicted data with a reference value (e.g., 0.5). For example, when the probability value of the predicted data is equal to or greater than the reference value, the predicted data may be converted into the first value (1), and when the probability value of the predicted data is less than the reference value, the predicted data may be converted into the second value (0).

According to the embodiment, the controller 120 may convert the predicted data based on the number of charge/discharge cycles in which the predicted data has the first value. That is, the controller 120 may convert the predicted data according to the distribution of predicted data according to the cycle.

For example, the controller 120 may convert the predicted data for all charge/discharge cycles into the first value when the number of charge/discharge cycles in which the predicted data has the first value is equal to or greater than a preset ratio. Since when the predicted data has the first value in more than a preset ratio of cycles among the all cycles, it means that a period in which the corresponding battery cell is predicted to be abnormal is long, the controller 120 may convert the predicted data in all cycles into the first value in order to reduce prediction inaccuracy. The preset ratio may be set to, for example, 20%.

When the number of charge/discharge cycles in which the predicted data has the first value is less than the preset ratio, the controller 120 may convert the predicted data for all charge/discharge cycles into a median value of the predicted data. That is, the controller 120 may convert the predicted data for all cycles into a value in more cycles between the first value and the second value.

The controller 120 may reduce the inaccuracy of abnormal prediction by converting the predicted data in this way.

According to still another embodiment, the controller 120 may preprocess the predicted data by removing some of the predicted data.

The controller 120 may remove data outside a preset range by applying an interquartile range (IQR) to the predicted data. In this way, the controller 120 may remove outliers (noise) from the predicted data, thereby increasing the diagnostic accuracy.

The interquartile range is a type of method of analyzing the distribution of a plurality of data groups, and may mean a method of dividing the distribution of pieces of data into four ranges and excluding 1/4 ranges at both ends as outliers. In this case, a value obtained by subtracting a first quartile (25% percentile, Q1) from a third quartile (75% percentile, Q3) of the data distribution may be used as a reference (IQR = Q3 - Q1). For example, the controller 120 may remove data that fall within a range exceeding Q3 + 1.5 * (Q3 - Q1) and a range less than Q1 - 1.5 * (Q3 - Q1) from the distribution of pieces of the predicted data as outliers.

According to the embodiment, the controller 120 may derive a diagnosis result for each cycle of each of a plurality of battery cells based on the preprocessed predicted data.

In the embodiment, the controller 120 may derive the diagnosis result by comparing the preprocessed predicted data with a threshold value. The threshold value may be preset, for example, to 0.5.

For example, when the preprocessed predicted data in a specific cycle of a specific cell is less than the threshold value, the controller 120 may determine the diagnosis result for the corresponding cycle as normal. Conversely, when the preprocessed predicted data in the specific cycle of the specific cell is equal to or greater than the threshold value, the controller 120 may determine the diagnosis result for the corresponding cycle as abnormal.

In addition, when as the diagnosis result, it is confirmed that the battery cell is abnormal, the controller 120 may provide information about the abnormal battery cell to a user. For example, the controller 120 may provide the information about the defective battery cell to a user terminal through a communication unit (not shown), and may also provide information about the defective battery cell through a display equipped in a vehicle or a charger.

The battery diagnostic device 100 may perform abnormal diagnosis for each cycle of each cell in this way, and accordingly, may confirm a point in time at which an abnormality has occurred in the abnormal battery cell, and may increase the diagnostic accuracy for the entire battery pack and reduce the over-detection rate.

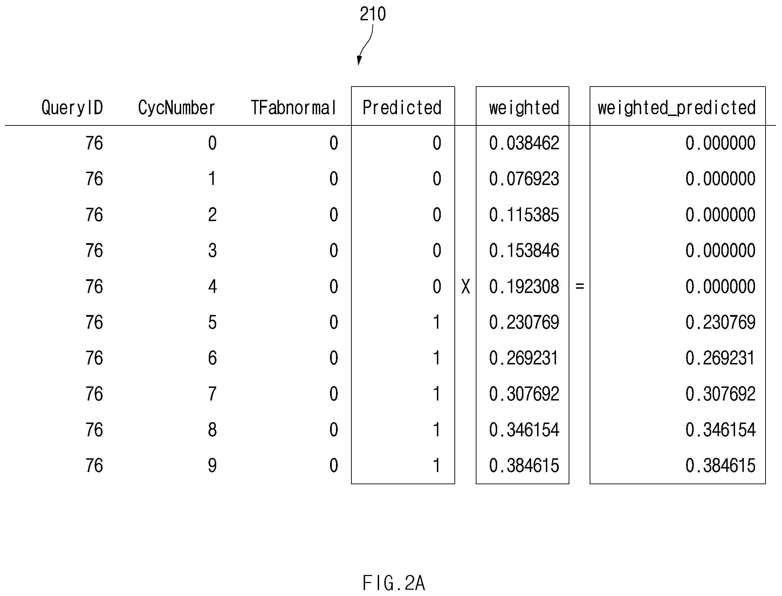

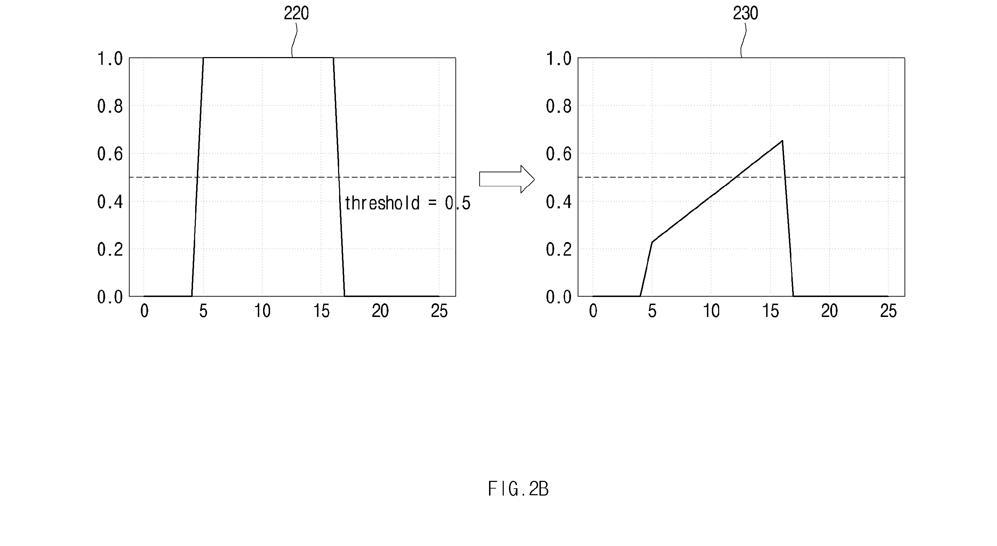

FIGS. 2a and 2b are views showing an example of a result obtained by applying a preprocessing method according to an embodiment disclosed herein.

First, referring to FIG. 2a, the controller 120 may preprocess the predicted data by assigning a weight to the predicted data, and an example 210 of the preprocessed predicted data is shown.

The controller 120 may calculate the predicted data (Predicted) for each cycle (CycNumber) of a specific cell (QueryID) and may assign a weight (weighted) according to the cycle to the predicted data. The controller 120 may preprocess (weighted_predicted) the predicted data by calculating the predicted data and the weight. In FIG. 2a, a product operation (or inner product) of the predicted data and the weight is shown as an example, but it is obvious that various operations may be applied to the calculation of the weight.

FIG. 2b shows an example of a graph 230 showing the result of preprocessing the predicted data 220 by the controller 120 assigning the weight to the predicted data 220. In FIG. 2b, an x-axis represents a cycle and a y-axis represents a data value. The controller 120 may reduce a diagnostic over-detection rate by preprocessing the predicted data by assigning the weight according to the cycle to the predicted data. Referring to FIG. 2b, it may be confirmed that the number of cycles determined as abnormal is reduced as the weight is assigned.

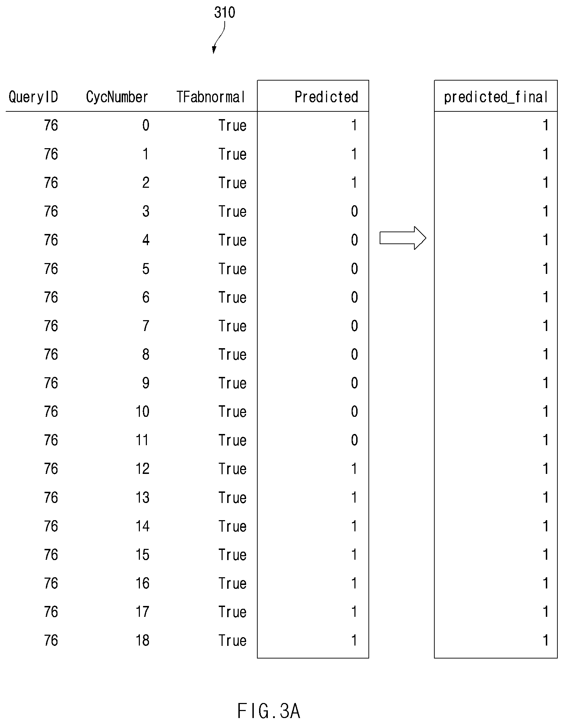

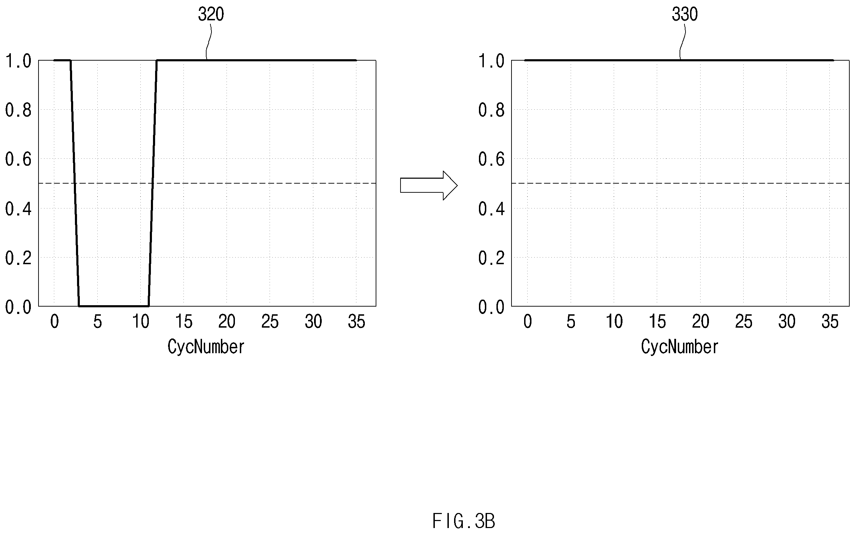

FIGS. 3a and 3b are views showing an example of a result obtained by applying a preprocessing method according to another embodiment disclosed herein.

Referring to FIG. 3a, the controller 120 may perform preprocessing by converting a value of data according to the data distribution of predicted data, and an example 310 of preprocessed predicted data is shown.

For example, in FIG. 3a, the controller 120 may convert predicted data for all cycles into a first value since the number of cycles (10) having the first value (1) is equal to or greater than a preset ratio (0.2) of the total number of cycles (18). Predicted data 330 converted by preprocessing predicted data 320 may be expressed as in FIG. 3b.

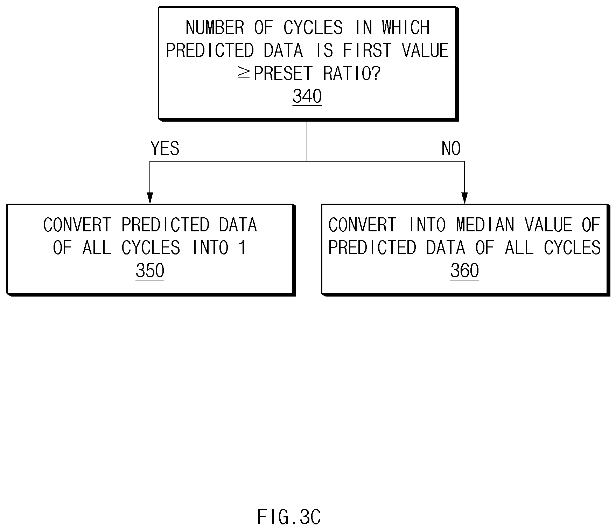

FIG. 3c is a diagram showing a process in which a preprocessing method according to another embodiment disclosed herein is applied.

Referring to FIG. 3c, the controller 120 may convert the predicted data according to the number of cycles in which the predicted data is the first value.

First, the controller 120 may check whether the number of cycles in which the predicted data is a first value is equal to or greater than a preset ratio (340).

The controller 120 may convert the predicted data of all cycles into the first value when the number of cycles in which the predicted data is the first value is equal to or greater than the preset ratio (YES) (350). Conversely, the controller 120 may convert the predicted data of all cycles into a median value of the predicted data when the number of cycles in which the predicted data is the first value is less than the preset ratio (NO) (360).

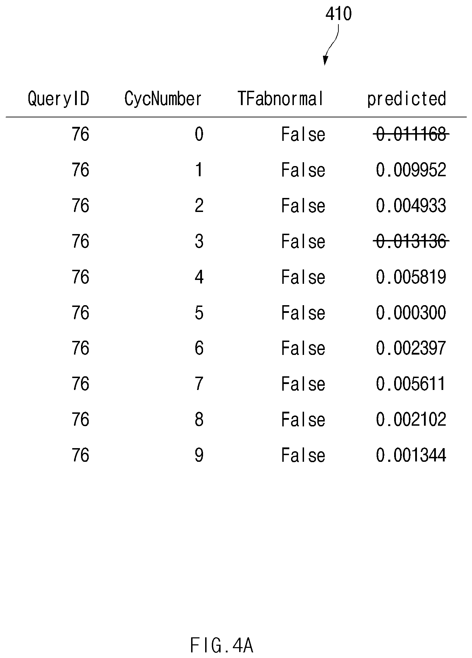

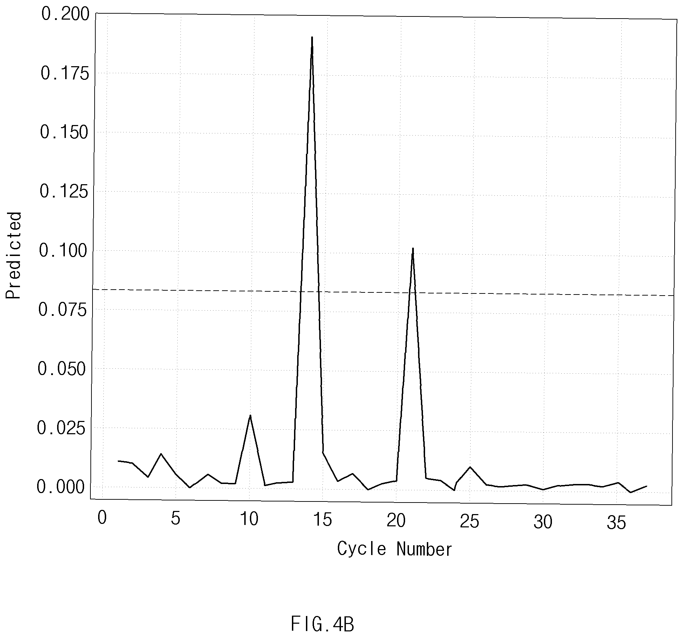

FIGS. 4a and 4b are views showing an example of a result obtained by applying a preprocessing method according to yet another embodiment disclosed herein.

Referring to FIG. 4a, the controller 120 may preprocess a portion of the predicted data by removing outliers, and an example 410 of the preprocessed predicted data is shown. In FIG. 4a, it may be confirmed that the predicted data of first and fourth cycles have been removed.

The controller 120 may apply an interquartile range to the predicted data to remove data outside a preset range. Data located in a region above a dotted line in FIG. 4b means data that is outside the preset range, and thus, the data may be removed.

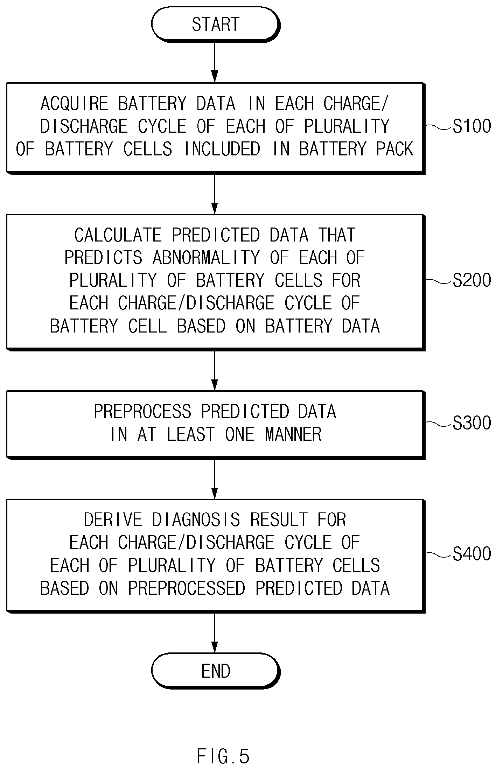

FIG. 5 is a flowchart for describing a method of diagnosing a battery according to an embodiment disclosed herein.

Referring to FIG. 5, a method of diagnosing a battery may include acquiring battery data in a charge/discharge cycle of each of a plurality of battery cells included in a battery pack (step S100), calculating predicted data that predicts an abnormality of each of the plurality of battery cells for each charge/discharge cycle of the battery cell based on the battery data (step S200), preprocessing the predicted data in at least one manner (step S300), and deriving a diagnosis result for each charge/discharge cycle of each of the plurality of battery cells based on the preprocessed predicted data (step S400).

In step S100, the information acquisition unit 110 may acquire battery data for each charge/discharge cycle for each battery cell. The battery data may include voltage data.

In step S200, the controller 120 may calculate predicted data for each charge/discharge cycle for each battery cell. In the embodiment, the controller 120 may acquire the predicted data using a pre-trained diagnostic model, and the predicted data may mean data predicting the abnormality of a specific cell in a specific cycle.

In step S300, the controller 120 may preprocess the predicted data in at least one manner. In an embodiment, the controller 120 may preprocess the predicted data by assigning a weight determined according to the cycle to the predicted data. In another embodiment, the controller 120 may preprocess the predicted data based on the distribution of predicted data values according to the cycle. In still another embodiment, the controller 120 may preprocess the predicted data by removing data based on a range of the predicted data.

In step S400, the controller 120 may derive a diagnosis result for each charge/discharge cycle of each of the plurality of battery cells based on the preprocessed predicted data. In the embodiment, the controller 120 may derive the diagnosis result by comparing the preprocessed predicted data with a threshold value. For example, when the preprocessed predicted data of the specific cell in the specific cycle is equal to or greater than a threshold value, the controller 120 may diagnose the corresponding cell as abnormal in the corresponding cycle.

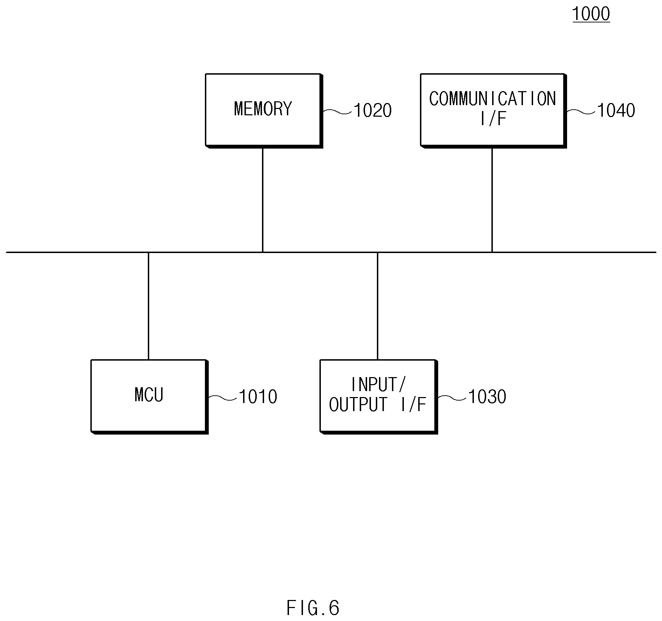

FIG. 6 is a block diagram showing a hardware configuration of a computing system for performing a method of operating a battery diagnostic device according to an embodiment disclosed herein.

Referring to FIG. 6, a computing system 1000 according to an embodiment disclosed herein may include a microcontroller unit (MCU) 1010, a memory 1020, an input/output interface I/F 1030, and a communication I/F 1040.

The MCU 1010 may be a processor that executes various programs stored in the memory 1020, processes various information including time series data and the like of the battery through the programs, and performs functions of the controller included in the battery diagnostic device shown in the aforementioned FIG. 1.

The memory 1020 may store various programs for performing the functions of the battery diagnostic device. In addition, the memory 1020 may store various information including battery data, diagnostic prediction results, and the like, and may store a pre-trained diagnostic model.

A plurality of memories 1020 may be provided as needed. The memory 1020 may be a volatile memory or a non-volatile memory. As the volatile memory, the memory 1020 may be a random-access memory (RAM), dynamic RAM (DRAM), static RAM (SRAM), or the like. For the memory 1020 as the non-volatile memory, a read-only memory (ROM), a programmable ROM (PROM), an electrically alterable ROM (EAROM), an erasable programmable ROM (EPROM), an electrically erasable programmable ROM (EEPROM,) a flash memory, or the like may be used. The examples of memories 1020 listed above are only exemplary and are not limited to the examples.

The input/output I/F 1030 may provide an interface that connects an input device (not shown) such as a keyboard, mouse, touch panel, or the like, and an output device such as a display (not shown), to the MCU 1010 to enable data transmission and reception.

The communication I/F 1040 is a component that may transmit and receive various data to and from the server, and may be any device that may support wired or wireless communication. For example, the battery diagnostic device may transmit and receive various types of information, including battery time series data, to and from a separately provided external server through the communication I/F 1040.

By being recorded in the memory 1020 and processed by the MCU 1010 in this way, a computer program according to an embodiment disclosed herein may be implemented, for example, as a module that performs each of the functions shown in FIG. 2.

Although all the components constituting the embodiments disclosed herein have been described as being combined or operating in combination as one, the embodiments disclosed herein are not necessarily limited to these embodiments. That is, within the scope of the purpose of the embodiments disclosed herein, all of the components may be selectively combined and operated one or more times.

Terms such as "include," "comprise," or "have" described above mean that the corresponding component can be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. A battery diagnostic device comprising:
an information acquisition unit configured to acquire battery data in a charge/discharge cycle of each of a plurality of battery cells included in a battery pack; and
a controller configured to:
calculate predicted data that predicts an abnormality of each of the plurality of battery cells for each charge/discharge cycle of the battery cell based on the battery data;
preprocess the predicted data in at least one manner; and
derive a diagnosis result for each charge/discharge cycle of each of the plurality of battery cells based on the preprocessed predicted data.

2. The battery diagnostic device of claim 1, wherein the controller converts the predicted data by assigning a weight determined according to the charge/discharge cycle to the predicted data.

3. The battery diagnostic device of claim 1, wherein the controller, for each of the plurality of battery cells:
expresses the predicted data as binary data; and
converts the predicted data based on the number of charge/discharge cycles in which the predicted data has a first value.

4. The battery diagnostic device of claim 3, wherein the controller, for each of the plurality of battery cells:
converts the predicted data for all charge/discharge cycles into the first value when the number of charge/discharge cycles in which the predicted data has the first value is equal to or greater than a preset ratio; and
converts the predicted data for all charge/discharge cycles into a median value of the predicted data when the number of charge/discharge cycles in which the predicted data has the first value is less than the preset ratio.

5. The battery diagnostic device of claim 1, wherein the controller applies an interquartile range (IQR) to the predicted data to remove data outside a preset range.

6. The battery diagnostic device of claim 1, wherein the controller compares the preprocessed predicted data with a threshold value to derive the diagnosis result.

7. The battery diagnostic device of claim 1, wherein the controller acquires the predicted data using a pre-trained diagnostic model.

8. A method of diagnosing a battery, comprising:
acquiring battery data in a charge/discharge cycle of each of a plurality of battery cells included in a battery pack;
calculating predicted data that predicts an abnormality of each of the plurality of battery cells for each charge/discharge cycle of the battery cell based on the battery data;
preprocessing the predicted data in at least one manner; and
deriving a diagnosis result for each charge/discharge cycle of each of the plurality of battery cells based on the preprocessed predicted data.

9. The method of claim 8, wherein in the preprocessing of the predicted data in at least one manner, the predicted data is converted by assigning a weight determined according to the charge/discharge cycle to the predicted data.

10. The method of claim 8, wherein in the preprocessing of the predicted data in at least one manner, the predicted data is expressed as binary data, and the predicted data is converted based on the number of charge/discharge cycles in which the predicted data has a first value.

11. The method of claim 10, wherein in the preprocessing of the predicted data in at least one manner,
the predicted data for all charge/discharge cycles is converted into the first value when the number of charge/discharge cycles in which the predicted data has the first value is equal to or greater than a preset ratio, and
the predicted data for all charge/discharge cycles is converted into a median value of the predicted data when the number of charge/discharge cycles in which the predicted data has the first value is less than the preset ratio.

12. The method of claim 8, wherein the preprocessing of the predicted data in at least one manner, an interquartile range (IQR) is applied to the predicted data to remove data outside a preset range.
